# EUROPEAN PATENT APPLICATION

(11) **EP 3 419 165 A1**
(43) Date of publication of application: **26.12.2018**
(21) Application number: 17177630.5
(22) Date of filing: 23.06.2017
(51) Int. Cl.: H03H 7/01, H03M 1/12

(54) **ANALOGUE TO DIGITAL CONVERSION APPARATUS AND METHOD**

(71) Applicant: Vestel Elektronik Sanayi ve Ticaret A.S., 45030 Manisa (TR)
(72) Inventor: SARIARSLAN, Muhammet Kürsat, 45030 Manisa (TR)
(74) Representative: Flint, Adam

(57) **Abstract**

Analogue to digital conversion apparatus (1) comprises an analogue to digital convertor (ADC, 2), which generates a digital output (8). An analogue reference signal (4), having a first noise component, and an analogue input signal (6), having a second noise component, are received. Those signals (4, 6) are modified before they are supplied to the ADC (2), such that the modified signals (4', 6') have matching composite noise components, each corresponding to the first and second noise components combined. The ADC (2) generates the digital output (8) corresponding to the modified input signal (6') based on the modified reference signal (4'), whereby the matching composite noise components cancel each other out such that the digital output (8) is independent of the first and second noise components.

## Description

### Technical Field

The present disclosure relates to an analogue to digital conversion apparatus and method.

### Background

An analogue to digital converter (ADC) is an electrical system that converts an analogue input signal to a digital output. Many electronic devices use an ADC circuit that can convert analogue signals to digital form. For example, ADC circuits can be used to detect changes in an analogue input signal or to measure different signal levels of an analogue input signal. When an ADC is active, it evaluates the analogue input signal (input feed) according to a reference signal (reference feed). The reference and input feeds may be received via reference and input supply lines respectively. The input feed may for example be a continuously varying voltage or current. The digital output, by contrast, is a quantised signal that varies between a finite number of discrete levels or other discrete waveforms (two in the case of binary output). These can for example be discrete voltage or current levels. If there is noise present on the input signal or reference signal (or both), this can cause inaccuracies in the digital output.

### Summary

According to a first aspect disclosed herein, there is provided analogue to digital conversion apparatus comprising: signal-combining circuitry; an analogue to digital converter (ADC); reference signal processing circuitry configured to: receive an analogue reference signal having a desired reference component and a first noise component, and provide: a second version of the reference signal to the signal-combining circuitry, and a first version of the reference signal to a filter of the reference signal processing circuitry, that filter being configured to filter the first version of the reference signal to filter out the desired reference component, thereby isolating the first noise component in the filtered reference signal; and input signal processing circuitry configured to: receive an analogue input signal having a desired input component and a second noise component, and provide: a second version of the input signal to the signal-combining circuitry, and a first version of the input signal to a filter of the input signal processing circuitry, that filter being configured to filter the first version of the input signal to filter out the desired input component, thereby isolating the second noise component in the filtered input signal; wherein the signal-combining circuitry is configured to: 1) generate a modified reference signal by combining the filtered input signal with the second version of the reference signal, and 2) generate a modified input signal by combining the filtered reference signal with the second version of the input signal, whereby the modified signals have matching composite noise components, each corresponding to the first and second noise components combined; and wherein the ADC has a reference input and a signal input connected to receive the modified reference signal and the modified input signal respectively, and is configured to generate a digital output corresponding to the modified input signal, based on the modified reference signal, whereby the matching composite noise components cancel each other out such that the digital output is independent of the first and second noise components.

Examples of aspects disclosed herein provide analogue to digital conversion circuitry with robustness to noise, without any need for noise filters on the supply or reference lines directly.

In embodiments of the first aspect, the analogue to digital conversion apparatus may comprise a buffer coupled to the input signal processing circuitry and the signal-combining circuitry to provide the second version of the input signal from the input signal processing circuitry to the signal-combining circuitry.

The analogue to digital conversion apparatus may comprise a buffer coupled to the reference signal processing circuitry and the signal-combining circuitry to provide the second version of the reference signal from the reference signal processing circuitry to the signal-combining circuitry.

The filter of the reference signal processing circuitry may be a high pass filter.

The filter of the input signal processing circuitry may be a high pass filter.

High pass filters are used for high-frequency noise, which avoids the use of low pass filters on the input and supply lines. In practice, low pass noise filters can be quite ineffective at filtering out high frequency noise and a significant performance benefit can therefore be achieved using the present techniques instead.

More generally, there are situations where it is more effective in practice to use filters to isolate noise (in accordance with the present teachings) than to try and filter out noise from the signals directly.

The filter of the input signal processing circuitry may have a variable cut-off frequency.

The analogue to digital conversion apparatus may comprise a controller configured to adapt the cut-off frequency according to the input signal.

The controller may be configured to determine a type of the input signal and to adapt the cut-off frequency according to the determined type of the input signal.

The filter of the reference signal processing circuitry may have a fixed cut-off frequency.

The analogue to digital conversion apparatus may be configured to receive and process the analogue signals as voltage signals.

A second aspect disclosed herein provides a television, television card or television controller embodying analogue to digital conversion apparatus according to the first aspect or any embodiment thereof.

A third aspect disclosed herein provides a method of performing analogue to digital conversion, the method comprising: receiving, at reference signal processing circuitry, an analogue reference signal having a desired reference component and a first noise component; providing a first version of the reference signal to a filter of the reference signal processing circuitry, wherein that filter filters the first version of the reference signal to filter out the desired reference component, thereby isolating the first noise component in the filtered reference signal; providing a second version of the reference signal to signal-combining circuitry; receiving, at input signal processing circuitry, an analogue input signal having a desired input component and a second noise component; providing a first version of the input signal to a filter of the input signal processing circuitry, wherein that filter filters the first version of the input signal to filter out the desired input component, thereby isolating the second noise component in the filtered input signal; providing a second version of the input signal to the signal-combining circuitry; generating, by the signal-combining circuitry, 1) a modified reference signal by combining the filtered input signal with the second version of the reference signal, and 2) a modified input signal by combining the filtered reference signal with the second version of the input signal, whereby the modified signals have matching composite noise components, each corresponding to the first and second noise components combined; and supplying the modified reference signal to a reference input of a ADC and the modified input signal to a signal input of the ADC, wherein the ADC generates a digital output corresponding to the modified input signal, based on the modified reference signal, whereby the matching composite noise components cancel each other out such that the digital output is independent of the first and second noise components.

In embodiments of the third aspect, any feature of the first or second aspects or any embodiments may be implemented.

### Brief Description of the Drawings

To assist understanding of the present disclosure and to show how embodiments may be put into effect, reference is made by way of example to the accompanying drawings in which:
Figure 1 shows schematically an example of an ADC for performing analogue to digital signal conversion;
Figure 2 shows schematically an example of analogue to digital conversion apparatus according to aspects described herein;
Figure 3 shows an example of a potential divider that can be used to provide two versions of a voltage signal; and
Figure 4 shows example modified reference and input signals having matching noise components, which cancel each other out.

### Detailed Description

As noted, an ADC is an electrical system that converts an analogue input signal to a digital output. An ACD may receive an analogue reference signal and an analogue input signal, and generate, based on the analogue reference signal, a digital output corresponding to the analogue input signal, typically by quantizing the input signal using the reference signal as a reference for the quantization. The input and reference signals may be voltages and the digital output may have a value of 0 when the input voltage is less than the reference voltage and a value of 1 when the input voltage is greater than the reference voltage, for example. Alternatively, the reference and input signals may be currents, the digital output may have a value of 0 when the input current is less than the reference current and a value of 1 when the input current is greater than the reference current, for example. As will be appreciated, this is a simple two-bit ADC example, and a higher-bit ADC can generate a digital output that is a combination of 0s and 1s using more complex quantization. Here, "0" and "1" are logical values which can be represented by any two different voltage or current levels.

If there is noise present on the input signal or reference signal (or both), this can cause inaccuracies in the digital output. In particular, where an AC supply voltage is used as the reference signal, this can lead to AC noise on either or both of the input or reference signals. Noise can occur in other situations where there is no control over the supply voltage. There is a particular risk of noise if the input or reference lines are weak in terms of power, if there is electrical coupling occurring between signals or if either of the signal lines has a weak ground connection. Existing solutions attempt to separately check for noise on the input and reference feed lines, and attempt to clean the signals with noise filters. However, there are various problems with this approach. Low frequency power noises in particular, cannot be cleaned effectively with simple filters. It may also not be possible to position the required noise filters on small size electronic cards, such as small sized television (TV) cards.

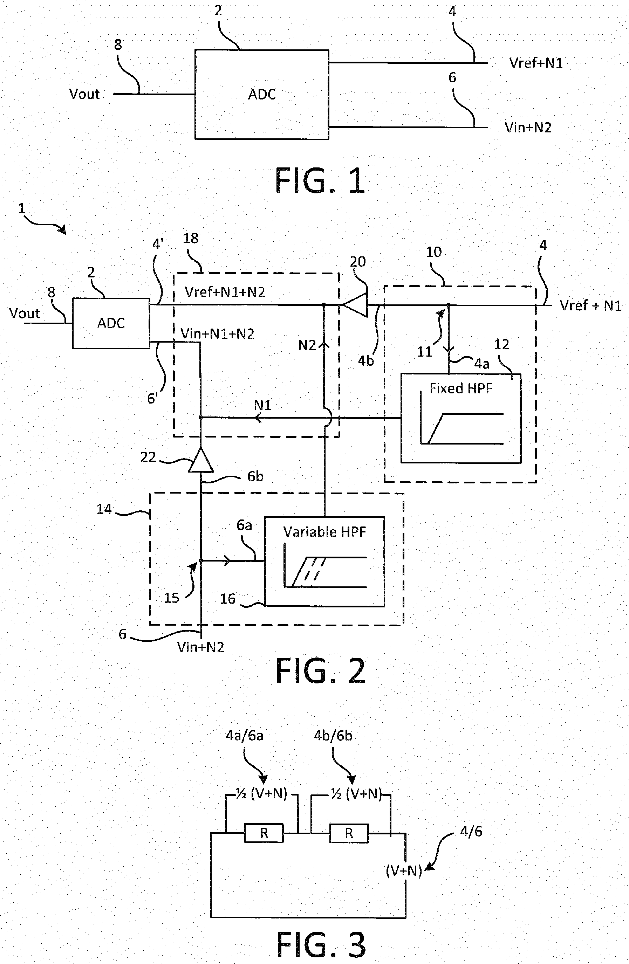

Figure 1 shows an example of an ADC 2 having a reference input connected to receive a reference signal 4 and a signal input connected to receive an input signal 6. The input and reference signals 6, 4 are voltages in this example. The ADC 2 generates a digital output 8, embodied as an output voltage Vout, by quantizing the input signal 6, such that the digital output 8 is a quantized version of the input voltage 6. The digital output 8 is generated using the reference voltage 4 as a reference for the quantization. The digital output 8 can be a sequence of bits (0 and 1) where, as noted, 0 and 1 are logical values which can be represented by any two discrete voltage levels of Vout. Where there is noise on either or both of the signals 4, 6, this can cause errors in the digital output 8. For example, an increase in the reference voltage 4 can cause a change in the digital output 8 indicating that a drop has occurred in the input voltage 6 even though there has been no change in the input voltage 6. Likewise, a decrease in the reference voltage 4 can cause a change in the digital output 8 that indicates an increase in the input voltage 6 has occurred even though no such change has occurred in the input voltage 6. This is because the ADC 2 effectively performs a subtractive operation between the input voltage 6 and reference voltage 4 meaning that changes in either signal may be reflected in the digital output 8. In particular, it has been recognised that the digital output 8 can behave unexpectedly when the input voltage 6 and reference voltage 4 have non-matching noise components. In Figure 1, the reference voltage 4 is denoted Vref+N1 where N1 is a noise component of the reference voltage 4 and Vref is a desired reference component of the reference voltage 4 (N1 and Vref being frequency components of the reference signal 6). The input voltage 6 is denoted Vin+N2 where N2 is a noise component of the input voltage 6 and Vin is a desired input component of the input voltage 6 (Vin and N2 being frequency components of the input signal 4).

Figure 2 shows a circuit diagram for an example of analogue to digital conversion apparatus 1. The analogue to digital conversion apparatus 1 is shown to comprise a ADC 2 of the kind shown in Figure 1 and described above. A benefit of the apparatus 1 is that it is not necessary for the input and reference signals 6, 4 to be noiseless. This is because the apparatus 1 modifies those signals, in the manner described below, before they are supplied to the ADC 2 so that the modified signals have matching noise components. The matching noise components cancel each other out when the quantization is performed, making the digital output 8 independent of the individual noise components N1, N2 of the reference and input signals 4, 6 respectively.

In Figure 2 the reference voltage 4 (Vref+Nl) and input voltage 6 (Vin+N2) are not received directly by the ADC 2. Rather, the input voltage 4 is received by reference signal processing circuitry 10 of the analogue to digital conversion apparatus 1 (reference stage), shown to comprise a first high pass filter 12. Likewise, the input voltage 6 is received by input signal processing circuitry 14 of the analogue to digital conversion apparatus 1 (input stage), shown to comprise a second high pass filter 16. As will become apparent, high pass filters are suitable when the noise components N1, N2 are higher frequency components than the desired components Vin, Vref respectively, which tends to be the case in at least some contexts.

As shown, the reference signal processing circuitry 10 generates two matching versions of the reference voltage 4 - that is, a first version 4a and a second version 4b - and provides the first version 4a of the input voltage 4 to the first high pass filter 12. The first high pass filter 12 filters that version 4a of the reference voltage 4 in order to filter out the desired reference component Vref therefrom, leaving only the noise component N1 in the output of the first high pass filter 12. In this manner, the first high pass filter 12 isolates the noise component N1 from the desired reference component Vref.

Similarly, the input processing circuitry 14 generates two matching versions of the input voltage 6 - that is, a first version 6a and a second version 6b - and provides the first version 6a of the input voltage 6 to the second high pass filter 16. The second high pass filter 16 filters out the desired input component Vin therefrom, leaving only the noise component N2 in the output of the second high pass filter 16. In this manner, the second high pass filter 16 isolates the noise component N2 from the desired input component Vin.

The analogue to digital conversation apparatus 1 is also shown to comprise signal-combining circuitry 18 (combining stage), which receives the second (unfiltered) version 4b of the reference voltage 4 provided by the reference signal processing circuitry 10 and the second (unfiltered) version 6b of the input voltage 6 provided by the input signal processing circuitry 14. The second version 4b of the reference voltage 4 has both the desired reference component Vref and the noise component N1; similarly, the second version 6b of the input voltage 6 has both the desired input component Vin and the noise component N2. As well as receiving these two signals, the signal-combining circuitry 18 also receives the isolated noise component N1 from the first high pass filter 12 of the reference signal processing circuitry 10, and the isolated noise component N2 from the second high pass filter 16 of the input signal processing circuitry 14.

As shown in Figure 2, the signal-combining circuitry 18 sums the isolated noise component N2 (i.e. the input signal noise component) with the second version 46 of the reference voltage 4 in order to generate a modified reference voltage 4' having a composite noise component N1 + N2, with N1 having come from the second version 4b of the reference voltage 4 and N2 from the output of the second high pass filter 16 of the input processing circuitry 14. In a similar manner, the signal-combining circuitry 18 sums the isolated noise component N1 (i.e. the reference signal noise component) with the second version 6b of the input voltage 6 in order to generate a modified input voltage 6', which also has a composite noise component N1 + N2; however, here N1 has come from the output of the first high pass filter 12 of the reference signal processing circuitry 10 and N2 has come from the second version of the input voltage 6b. The modified reference voltage 4' is supplied to the reference input of the ADC 2 and the modified input voltage 6' is provided to the signal input of the ADC 2. In other words, the isolated noise components are "exchanged" at the combining stage 18 to ensure the inputs to the ADC 2 have matching noise components. Because the modified signals 4' and 6' have matching composite noise components (N1 + N2), these noise components cancel each other out when the quantization is performed which means that the digital output 8 of the ADC 2 is independent of the noise components N1 and N2, whatever they may be.

In the circuit of Figure 2, what constitutes noise is determined by the cut-off frequencies of the high pass filters 12, 16. With regards to the reference voltage 4, the noise component N1 means any frequency components of the reference voltage 4 that are not filtered out by the first high pass filter 12; that is, the frequency components below the frequency cut-off of that filter. Likewise, with regards to the input voltage 6, the noise component N2 means any frequency components that are not filtered out by the second high pass filter 16; that is, frequency components above the cut-off frequency of that filter. The desired components Vref, Vin are the remaining frequency components of the signal in question, and the cut off frequencies can be set to specify these as desired.

The quantization performed by the ADC 2 can be performed in various ways. For example the ADC 2 may compare the modified input signal 6' with the modified reference signal 4'. The ADC 2 may apply a subtractive operation to the modified signals 6', 4', e.g. the digital output 8 depend on a difference between those signals 4' 6'. For example, it could be a quantized version of a difference between those signals 4', 6', such as (Vin+N1+N2) - (Vref+N1+N2) = Vin-Vref.

In one example at least, the second high pass filter 16 of the input signal processing circuitry 14 has an adjustable cut-off frequency. This provides noise cleaning with relatively coarse control, but that will be sufficient in many contexts.

The desired input component Vin of the input signal 6 may be the DC component (only) of the input voltage 6, or it may be a low frequency AC signal or it may be a high frequency AC signal. Accordingly, the cut-off frequency of the high pass filter 16 needs to be set correctly. For example, if the input signal 6 is an audio signal and the second high pass filter 16 has a cut-off frequency of 10 KHz, then all of the frequency components of the audio signal above 10 KHz are considered noise which may be excessive given that frequency components as high as 20 KHz can be audible. On the other hand, if the cut-off frequency of the filter is set too high then the interfering noises may not be detected at all. Accordingly, in general, the highest non-noise frequency needs to be determined according to the type of signal (e.g. 20 KHz for an audio signal). The frequency cut-off of the second high pass filter 16 can then be set according to a determined type of signal. For example, a maximum (non-noise) frequency can be determined according to the type of signal, and the cut-off frequency set at that value. This process can be performed adaptively by a controller of the apparatus 1 (not shown), such as a microcontroller or software executed on a CPU(s). Alternatively it can be fixed at the design stage as a fixed frequency filter, which may be sufficient in some contexts.

The first high pass filter 12 of the reference signal processing circuitry has a fixed cut-off frequency in this example, which means that it can be implemented with simpler circuitry. A fixed frequency filter 12 may be sufficient because, in the case of the reference voltage 4, the desired reference component Vref is generally simply the DC component of the reference voltage 4, with any AC components of the reference signal 6 being considered noise in this context.

The unfiltered version of the reference voltage 4b is supplied to the signal-combining circuitry 18 via a first buffer 20 of the apparatus 1, and the unfiltered version of the input voltage 6b is supplied to the signal-combining circuitry 18 via a second buffer 22 of the apparatus 1. The noise components N1, N2 received from the high pass filters 12, 16 are thus exchanged and combined with signals 6b, 4b after the buffers 20, 22. A buffer is an electrical component that may be used to prevent unwanted interference between circuit stages. Thus, the first buffer 20 prevents interference between stages 10 and 18, and the second buffer 22 prevents interference between stages 14 and 18. In particular, the buffers 20, 22 ensure that the input signal 6 and the reference signal 4 do not interfere with each other's DC levels.

Figure 3 shows an example potential divider circuit that can be used to provide two versions of a voltage input signal V+N. Such a circuit can be used at point 11 of the reference signal processing circuitry 10 to provide the first and second versions 4a, 4b of the reference voltage 4 (where V and N in Figure 3 correspond to Vref and N1 in that case). Such a circuit can also be used at point 15 of the input signal processing circuitry 14 to provide the first and second versions 6a, 6b of the input voltage 6 (where V and N in Figure 3 correspond to Vin and N2 in that case). The potential divider circuit is shown to comprise a first resistor and a second resistor connected in series with each other across the voltage V + N. The first and second resistors have substantially equal resistance R such that the voltage across each resistor is ½(V+N), with the voltage across the first resistor constituting the first version of the voltage V + N (4a/6a) and the voltage across the second resistor constituting the second version of the voltage V + N (4b/6b). In this respect, it is noted that the amplitude of those two versions of the relevant voltage need not be the same as the amplitude of the original voltage itself. In this example, the two versions of the voltage V+N have amplitudes that match each other but those amplitudes vary linearly with the original voltage V+N as one half of the amplitude of the original voltage.

When it comes to combining each of the unfiltered versions 4b/6b with the isolated noise component N2/N1 from the other signal, voltage summing circuitry can be used within the signal-combining circuitry 18. Voltage summing circuitry *per se* is well known in the art and is therefore not described in any more detail.

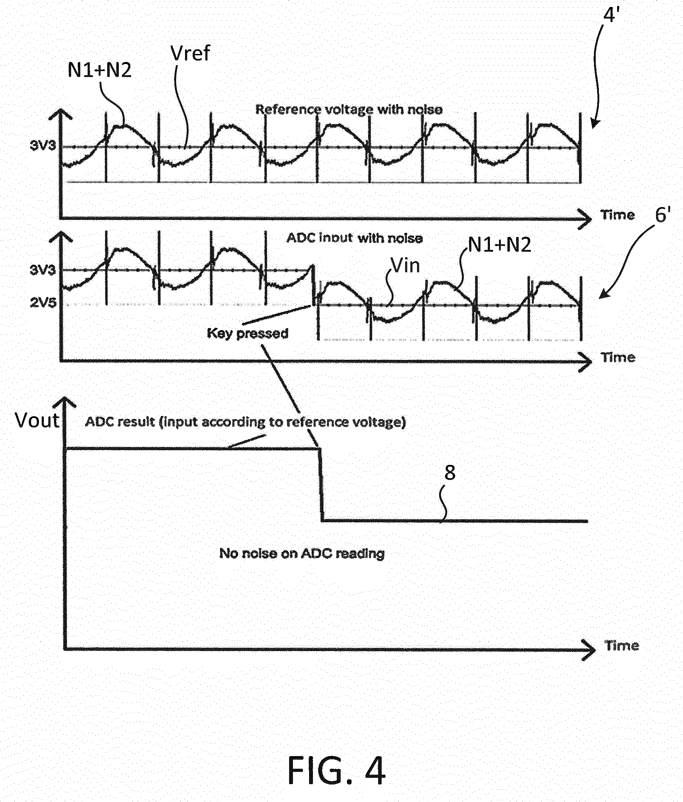

Figure 4 shows example graphs which show the modified reference (supply) voltage 4' with noise N1 + N2 and the modified input voltage 6' with matching noise N1 + N2. These noises are same so the ADC output 8 is noiseless in the sense that it is not affected by the presence of the individual noise components N1, N2 in the reference and input voltages 4, 6. In this example, Vref and Vin are DC components, where Vin can change in a stepwise fashion. A change in Vin is shown, which causes it to fall below Vref, resulting in a change in the digital output 8 of the ADC 2, embodied as Vout. In Figure 4, N1 + N2 is approximately sinusoidal but the shape of the noise is immaterial provided the modified reference and input signals 4', 6' have matching noise components.

As will be appreciated the ADC circuitry described above can be applied in various contexts, for example in a TV set, TV card or TV controller (e.g. remote control) among others.

It will be understood that the circuitry referred to herein may in practice be provided by a single chip or integrated circuit or plural chips or integrated circuits, optionally provided as a chipset, an application-specific integrated circuit (ASIC), as field-programmable gate array (FPGA).

The examples described herein are to be understood as illustrative examples of embodiments of the invention. Further embodiments and examples are envisaged.

For example, although high pass filters are used in the above, different types of filters can be used for different types of noise, such as low pass, band pass or band stop filters.

Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. Analogue to digital conversion apparatus comprising:
signal-combining circuitry;
an analogue to digital convertor;
reference signal processing circuitry configured to: receive an analogue reference signal having a desired reference component and a first noise component, and provide: a second version of the reference signal to the signal-combining circuitry, and a first version of the reference signal to a filter of the reference signal processing circuitry, that filter being configured to filter the first version of the reference signal to filter out the desired reference component, thereby isolating the first noise component in the filtered reference signal; and
input signal processing circuitry configured to: receive an analogue input signal having a desired input component and a second noise component, and provide: a second version of the input signal to the signal-combining circuitry, and a first version of the input signal to a filter of the input signal processing circuitry, that filter being configured to filter the first version of the input signal to filter out the desired input component, thereby isolating the second noise component in the filtered input signal;
wherein the signal-combining circuitry is configured to: 1) generate a modified reference signal by combining the filtered input signal with the second version of the reference signal, and 2) generate a modified input signal by combining the filtered reference signal with the second version of the input signal, whereby the modified signals have matching composite noise components, each corresponding to the first and second noise components combined; and
wherein the analogue to digital convertor has a reference input and a signal input connected to receive the modified reference signal and the modified input signal respectively, and is configured to generate a digital output corresponding to the modified input signal, based on the modified reference signal, whereby the matching composite noise components cancel each other out such that the digital output is independent of the first and second noise components.

2. Analogue to digital conversion apparatus according to claim 1, comprising:
a buffer coupled to the input signal processing circuitry and the signal-combining circuitry to provide the second version of the input signal from the input signal processing circuitry to the signal-combining circuitry.

3. Analogue to digital conversion apparatus according to claim 1 or claim 2, comprising:
a buffer coupled to the reference signal processing circuitry and the signal-combining circuitry to provide the second version of the reference signal from the reference signal processing circuitry to the signal-combining circuitry.

4. Analogue to digital conversion apparatus according to any of claims 1 to 3, wherein the filter of the reference signal processing circuitry is a high pass filter.

5. Analogue to digital conversion apparatus according to any of claims 1 to 4, wherein the filter of the input signal processing circuitry is a high pass filter.

6. Analogue to digital conversion apparatus according to any preceding claim, wherein the filter of the input signal processing circuitry has a variable cut-off frequency.

7. Analogue to digital conversion apparatus according to claim 6, comprising a controller configured to adapt the cut-off frequency according to the input signal.

8. Analogue to digital conversion apparatus according to claim 7, wherein the controller is configured to determine a type of the input signal and to adapt the cut-off frequency according to the determined type of the input signal.

9. Analogue to digital conversion apparatus according to any preceding claim, wherein the filter of the reference signal processing circuitry has a fixed cut-off frequency.

10. Analogue to digital conversion apparatus according to any preceding claim, which is configured to receive and process the analogue signals as voltage signals.

11. A television, television card or television controller embodying analogue to digital conversion apparatus according to any preceding claim.

12. A method of performing analogue to digital conversion, the method comprising:
receiving, at reference signal processing circuitry, an analogue reference signal having a desired reference component and a first noise component;
providing a first version of the reference signal to a filter of the reference signal processing circuitry, wherein that filter filters the first version of the reference signal to filter out the desired reference component, thereby isolating the first noise component in the filtered reference signal;
providing a second version of the reference signal to signal-combining circuitry;
receiving, at input signal processing circuitry, an analogue input signal having a desired input component and a second noise component;
providing a first version of the input signal to a filter of the input signal processing circuitry, wherein that filter filters the first version of the input signal to filter out the desired input component, thereby isolating the second noise component in the filtered input signal;
providing a second version of the input signal to the signal-combining circuitry;
generating, by the signal-combining circuitry, 1) a modified reference signal by combining the filtered input signal with the second version of the reference signal, and 2) a modified input signal by combining the filtered reference signal with the second version of the input signal, whereby the modified signals have matching composite noise components, each corresponding to the first and second noise components combined;
supplying the modified reference signal to a reference input of an analogue to digital convertor and the modified input signal to a signal input of the ADC, wherein the analogue to digital convertor generates a digital output corresponding to the modified input signal, based on the modified reference signal, whereby the matching composite noise components cancel each other out such that the digital output is independent of the first and second noise components.

13. A method according to claim 12, wherein the second version of the input signal is provided from the input signal processing circuitry to the signal-combining circuitry via a buffer.

14. A method according to claim 12 or claim 13 wherein the second version of the reference signal is provided from the reference signal processing circuitry to the signal-combining circuitry via a buffer.

15. A method according to any of claims 12 to 14, wherein at least one of the filters is a high pass filter.
